# EUROPÄISCHE PATENTANMELDUNG

(11) **EP 2 116 776 A1**
(43) Veröffentlichungstag der Anmeldung: **11.11.2009**
(21) Anmeldenummer: 08008506.1
(22) Anmeldetag: 06.05.2008
(51) Int. Cl.: F24D 11/00, F28D 20/00, H01L 31/058

(54) **Gebäudeklimaanlage und Verfahren zum Temperieren von Luft in einem Gebäude**

(71) Anmelder: LASCO Heutechnik GmbH, 5221 Lochen (AT)
(72) Erfinder: Landrichinger, Johann, 5221 Lochen (AT)
(74) Vertreter: Heyerhoff, Markus

(57) **Zusammenfassung**

Die Erfindung geht aus von einer Gebäudeklimaanlage mit einem solarthermischen System mit einem Solarluftkollektor (62)

Um ein großes Gebäude (2) über einen langen Zeitraum mit Wärme aus dem Solarluftkollektor (62) beheizen zu können, wird vorgeschlagen, dass die Gebäudeklimaanlage einen Schüttgutspeicher (24) als Wärmespeicher aufweist und ein Lüftungssystem (64) zum Einbringen von Luft aus dem Solarluftkollektor (62) in den Schüttgutspeicher (24) zum Durchströmen des Schüttgutspeichers (24) mit der Luft und zur Entnahme von Luft aus dem Schüttgutspeicher (24) zum Temperieren eines Gebäudes (2).

## Beschreibung

Die Erfindung betrifft eine Gebäudeklimaanlage mit einem solarthermischen System mit einem Solarluftkollektor. Außerdem betrifft die Erfindung ein Verfahren zum Temperieren von Luft in einem Gebäude, bei dem Luft mit einem Solarluftkollektor eines solarthermischen Systems erwärmt wird.

Zur Heizung von Industriegebäuden, wie großen Bürogebäuden oder Produktions- oder Lagerhallen, sind große Wärmemengen nötig. Im Sommer wiederum steht Wärme im Überfluss zur Verfügung, die bei geeigneter Speicherung im Winter und in den Übergangszeiten als Heizenergie genutzt werden könnte. Wärmespeicher ermöglichen die Speicherung thermischer Energie und ermöglichen dadurch eine zeitliche Entkopplung von Wärmeangebot und Wärmebedarf. Ein zu einem bestimmten Zeitpunkt vorhandener Wärmeüberschuss lässt sich zu einem späteren Zeitpunkt bei steigendem Bedarf oder sinkendem Angebot von Wärmeenergie verwenden und spart so wertvolle Rohstoffe ein. Saison-Wärmespeicher haben den Vorteil, dass man sie nicht nur dazu verwenden kann, im Winter den Wärmebedarf zu decken. Durch Abkühlen des Wärmespeichers im Winter lässt sich im darauf folgenden Sommer das niedrige Temperaturniveau des Wärmespeichers zur Gebäudekühlung verwenden.

Als Saison-Wärmespeicher sind Wasserspeicher, Gesteinsspeicher und Wasser-Kies-Speicher bekannt. Hierbei kann unterschieden werden zwischen angelegten Wärmespeichern, die nach außen isoliert sind und in der Regel direkt unter einer Erdoberfläche angelegt werden, und tiefer gelegenen Wärmespeichern, die ohne angelegte thermische Isolierung auskommen. Als solche sind beispielsweise Aquiferspeicher bekannt, die natürlich vorkommende, abgeschlossene Grundwasserschichten in Tiefen bis einige einhundert Metern als wärmespeicher nutzen. Erdwärmesonde-Wärmespeicher nutzen oberflächennahes oder tiefer gelegenes Erdreich als Speichermedium, wobei die Wärmeenergie durch Sonden in das Erdreich hineingetragen und später wieder entnommen wird.

Es ist eine Aufgabe der vorliegenden Erfindung, eine kostengünstige Gebäudeklimaanlage und ein kostengünstiges Verfahren zum Temperieren von Luft in einem Gebäude anzugeben, mit denen ein großes Gebäude, wie beispielsweise eine Fertigungshalle, über mehrere Monate mit im Sommer eingespeicherter Wärmeenergie beheizt werden kann.

Die auf die Gebäudeklimaanlage gerichtete Aufgabe wird gelöst durch eine Gebäudeklimaanlage der eingangs genannten Art, die erfindungsgemäß einen Schüttgutspeicher als Wärmespeicher aufweist und ein Lüftungssystem zum Einbringen von Luft aus dem Solarluftkollektor in den Schüttgutspeicher zum Durchströmen des Schüttgutspeichers mit der Luft und zur Entnahme von Luft aus dem Schüttgutspeicher zum Temperieren eines Gebäudes.

Ein Schüttgutspeicher als Wärmespeicher kann mit verhältnismäßig einfachen Mitteln sehr groß ausgeführt sein und kann - ohne dass seine Umgebung wasserdicht abgedichtet werden müsste - als Wärmespeicher verwendet werden. Auch Solarluftkollektoren können einfach hergestellt werden und bieten in Verbindung mit dem Schüttgutspeicher den Vorteil, dass die in einem Solarluftkollektor erwärmte Luft ohne Zwischenschaltung eines Wärmetauschers direkt in den Schüttgutspeicher gelenkt und dort abgekühlt werden kann. Auch die Entnahme von Wärme aus einem Schüttgutspeicher kann einfach gestaltet werden, indem dieser mit Luft durchströmt wird, die Luft hierbei erwärmt wird und beispielsweise direkt in das Gebäude zur Heizung eingebracht wird.

Der Schüttgutspeicher ist vorteilhafterweise ein Geröllspeicher und im Erdreich unter einem Fußboden des Gebäudes gelegen. Durch die Verwendung von Geröll kann der Schüttgutspeicher mit relativ geringem mechanischem Widerstand von Luft durchströmt werden. Die Anordnung unter dem Fußboden des Gebäudes bringt den zusätzlichen Vorteil, dass der Geröllspeicher als Fußbodenheizung für einen Gebäuderaum beziehungsweise eine Halle genutzt werden kann. Auf diese Weise kann das Gebäude sowohl mit Strahlungswärme als auch mit warmer Luft versorgt werden.

Das zu erwärmende Gestein des Schüttgutspeichers wird zweckmäßigerweise von der warmen Luft umströmt. Insbesondere wird das gesamte Speichervolumen des Schüttgutspeichers von Luft zum Wärmeübertrag von der Luft auf das Gestein oder andersherum durchströmt. Er hat daher vorteilhafterweise eine Einblasseite und eine gegenüberliegende Ausblasseite, zwischen denen das Speichervolumen angeordnet ist.

Eine gleichmäßige Durchströmung des Schüttgutspeichers ist Voraussetzung für eine gleichmäßige Ausnutzung des gesamten Speichervolumens. Unterschiedliche Packungsdichten oder verschieden große Schottersteine in verschiedenen Bereichen des Schüttgutspeichers können seine Durchströmung nachteilig beeinflussen. In Bereichen dichterer Packungen kann es zu einer geringeren Durchströmung kommen, was zu einem höheren Druckverlust und einer geringeren Speicherkapazität führt. Des Weiteren hat die Porosität des verwendeten Gesteins einen Einfluss auf den Luftwiderstand und die Wärmeübertragungsfähigkeit zwischen Luft und Gestein. Daher ist der Schüttgutspeicher vorteilhafterweise in Steingröße und Art homogen ausgeführt.

Um den Durchströmungswiderstand möglichst gering zu halten, ist der Schüttgutspeicher zweckmäßigerweise mit Steinen gefüllt, von denen zumindest 50 Gewichtsprozente größer als 1 Liter sind. Besonders vorteilhaft ist die Verwendung von Kopfsteinen mit einem Durchmesser von mehr als 15 cm, insbesondere bis zu einem Durchmesser von 25 cm, mit einem Anteil von über 50 Gewichtsprozente der Füllung des Schüttgutspeichers.

Zur Verwendung des Schüttgutspeichers als Fußbodenheizung ist dieser zweckmäßigerweise weniger als 1 m von einem Fußboden des Gebäudes beabstandet. Er kann von einer Temperierschicht vom Fußboden getrennt sein, um ein Überhitzen des Fußbodens zu vermeiden. Die Temperierschicht ist hierbei zweckmäßigerweise aus einem Material, dessen Wärmedämmung zumindest 5 x so hoch ist, wie die des Gesteins des Schüttgutspeichers. Es kann so ein kontrollierter Wärmeübertrag vom Schüttgutspeicher zum Fußboden erreicht werden. Als Wärmedämmung des Gesteins kann eine mittlere Wärmedämmung des Gesteins des Schüttgutspeichers verstanden werden.

Je nach Eigenschaft des um den Schüttgutspeicher herum angeordneten Erdreichs kann auch unter und seitlich des Schüttgutspeichers eine Wärmedämmschicht angeordnet werden, um einem Wärmeverlust, beispielsweise durch Fließwasser, entgegen zu wirken.

Der Schüttgutspeicher kann von warmer Luft erwärmt werden, die ihrerseits zuvor vom Solarluftkollektor erhitzt wurde. Dieser sollte möglichst großflächig ausgelegt sein, um genügend Wärme für eine mehrmonatige Heizung des Gebäudes zur Verfügung zu stellen. Ein Solarluftkollektor mit großer Fläche kann mit relativ geringem Aufwand hergestellt werden, indem dieser von doppelschaligen Gebäudehülle gebildet ist. Die Gebäudehülle kann ein oder mehrere Dach- und/oder Wandelemente zur Durchströmung mit Luft umfassen. Beim Durchströmen wird die Luft erwärmt und speichert als Transportmedium die Wärmeenergie.

Zweckmäßigerweise umfasst die Gebäudehülle ein doppelschaliges Dachelement, dessen oberste Dachschicht beispielsweise aus einem schwarz beschichteten Blech ausgeführt ist. Unter diesem Blech, welches die Wärmestrahlung der Sonne besonders gut absorbiert, strömt die zu erwärmende Luft hindurch. Alternativ kann die oberste Dachschicht eine Glasscheibe umfassen, unter der die zu erwärmende Luft hindurchströmt, mit einer darunter angeordneten opaken Schicht, die zweckmäßigerweise schwarz beschichtet ist. Nach unten wird der so gebildete Strömungskanal durch eine zweite Dachschicht abgegrenzt, z.B. die opake Schicht, die zusätzlich isoliert ausgeführt sein kann, sodass eine große Wärmeabstrahlung nach unten vermieden wird. Die Isolierung kann durch eine statisch nicht tragende, zur Isolierung vorgesehene Schicht bewirkt werden. Durch den Strömungskanal wird die Luft hindurch gesaugt oder geblasen und dabei von der Sonne je nach Außentemperatur, Sonneinstrahlung und in Abhängigkeit von der Durchströmungsgeschwindigkeit mehr oder weniger erwärmt.

Das Lüftungssystem dient zur Entnahme von Luft aus dem Schüttgutspeicher zum Temperieren des Gebäudes: im Herbst und im Winter zum Heizen des Gebäudes, im Sommer zum Kühlen. Die Luft aus dem Schüttgutspeicher kann direkt in das Gebäude geführt werden, da diese durch den Schüttgutspeicher angenehm temperiert und befeuchtet sein kann. Bei zu hoher Luftfeuchtigkeit der Luft aus dem Schüttgutspeicher kann ein Entfeuchter vorgesehen sein, der die Luft vor einem Einbringen in das Gebäude in einem vorgegebenen Maß entfeuchtet. Hierdurch wird Entfeuchtungswärme frei, die wiederum zur Heizung des Gebäudes genutzt werden kann.

Die durch den Schüttgutspeicher geführte Luft kann in einem Kreislauf vom Solarluftkollektor zum Schüttgutspeicher und wieder zum Solarluftkollektor und so weiter geführt sein. Zur Luftheizung des Gebäudes ist hierbei zweckmäßigerweise ein Wärmetauscher vorgesehen, der Wärme aus der vom Schüttgutspeicher kommenden Luft abnimmt.

Bei einer Beladung des Schüttgutspeichers mit Wärme erheizt sich dieser auf. Im Gegenzug kühlt die den Schüttgutspeicher durchdringende Luft ab und kann beispielsweise im Sommer zur Kühlung des Gebäudes verwendet werden. Bei Fortschreiten des Sommers heizt sich der Schüttgutspeicher immer weiter auf, sodass eine Kühlung zunehmend ineffektiv werden kann. Dieser Nachteil kann zwar durch eine entsprechend große Auslegung des Schüttgutspeichers gemildert werden. Allerdings soll der Schüttgutspeicher auf eine Temperatur erwärmt werden, die im Herbst und Winter eine Heizung des Gebäudes ermöglicht. Dies bedingt, dass der Schüttgutspeicher gegen Ende des Sommers nicht kühl bleiben sollte und somit eine Kühlwirkung des Schüttgutspeichers nachlässt.

Diesem Nachteil kann begegnet werden, wenn der Schüttgutspeicher in mehrere Bereiche oder Abschnitte aufgeteilt ist, die getrennt voneinander mit Wärme beladen werden können. Hierdurch kann zunächst ein Abschnitt erwärmt werden, wobei ein anderer Abschnitt noch kühl bleibt und bei bereits warmem ersten Abschnitt noch zur Kühlung des Gebäudes verwendet werden kann. Auf diese Weise kann der Schüttgutspeicher abschnittweise nacheinander mit Wärme beladen werden, wobei ein kühler Abschnitt zur Kühlung des Gebäudes lange zur Verfügung steht. In gleicher Weise kann auch eine wärmeentnahme abschnittsweise erfolgen. Die Auswahl des zu entladenden Abschnitts kann hierbei in Abhängigkeit von einem Wärmebedarf erfolgen. Je höher der Wärmebedarf ist, desto wärmer kann der zu entladende Abschnitt sein.

Bei einer Anordnung des Schüttgutspeichers unter einem Fußboden des Gebäudes ist es besonders vorteilhaft, wenn die Abschnitte untereinander angeordnet sind. So kann beispielsweise zunächst ein mitteltief gelegener Abschnitt erwärmt werden, sodass eine Heizung des Fußbodens im Sommer zunächst nicht oder nur in einem sehr geringen Maße stattfindet. Ein oder mehrere nächst tiefer gelegene Abschnitte bleiben kühl für eine Raumluftkühlung zu einem späteren Zeitpunkt. Gegen Ende des Sommers kann der oberste Abschnitt erwärmt werden, sodass dieser für einen warmen Fußboden in der Übergangszeit sorgt. In der ersten Übergangszeit kann zunächst'Luft aus einem relativ kühlen tieferen Abschnitt zur Heizung des Gebäudes verwendet werden, sodass ein wärmerer Abschnitt für kältere Zeiten zur Verfügung steht und nicht bereits zu Beginn der Heizperiode abgekühlt wird. So kann der Schüttgutspeicher beispielsweise von Abschnitt zu Abschnitt von unten nach oben abgekühlt werden und somit einem stetigen Sinken der Temperatur von aus dem Schüttgutspeicher abgeführter Luft entgegengewirkt werden.

Zur guten Durchströmung des Schüttgutspeichers mit Luft ist das Lüftungssystem zum Erzeugen einer Hauptströmungsrichtung von Luft im Schüttgutspeicher vorbereitet und weist zweckmäßigerweise ein Einlassrohr und ein Auslassrohr auf, die quer zur Hauptströmungsrichtung angeordnet sind und eine Vielzahl von Einlässen in den beziehungsweise Auslässen aus dem Schüttgutspeicher umfassen. Der Schüttgutspeicher kann gleichmäßig von der Einlassseite bzw. Einblasseite zur Auslassseite bzw. Ausblasseite durchströmt werden und hierdurch in seinem Speichervolumen gut genutzt werden.

Zur Einteilung des Schüttgutspeichers in verschiedene Bereiche oder Abschnitte umfasst das Lüftungssystem mehrer Lufteinlässe in den Schüttgutspeicher, die zweckmäßigerweise getrennt voneinander ansteuerbar sind. In gleicher Weise umfasst das Lüftungssystem zweckmäßigerweise mehrere Auslässe, die ebenfalls getrennt ansteuerbar sind. Hierdurch können Einlässe und insbesondere auch Auslässe gezielt zur Durchströmung mit Luft angewählt werden, wobei andere Einlässe beziehungsweise Auslässe verschlossen bleiben.

Zur Erzeugung von übereinander geschichteten Bereichen des Schüttgutspeichers kann das Lüftungssystem mehrere verschieden tiefe Einlassrohre und/oder Auslassrohre aufweisen, die jeweils eine Vielzahl von Einlässen in den bzw. Auslässen aus dem Schüttgutspeicher umfassen.

Um einer Wärmediffusion von einem Bereich in den anderen Bereich entgegen zu wirken kann der Schüttgutspeicher mit Hilfe zumindest einer Trennschicht zwischen den Bereichen in die Bereiche eingeteilt sein. Die Trennschicht kann ein Flies sein, das das Einströmen von Luft von einem Bereich in den anderen Bereich erschwert. Ebenfalls denkbar wäre eine Folie oder eine Trennwand.

Zur Steuerung eines Wärmeeintrags oder Wärmeaustrags in den Schüttgutspeicher bzw. aus diesem heraus umfasst die Gebäudeklimaanlage zweckmäßigerweise ein Steuersystem mit einem elektronischen Steuermittel zum auswählbaren Lenken von Einlassluft und/oder Auslassluft in verschiedene Bereiche des Schüttgutspeichers. So können beispielsweise Einlassrohre und/oder Auslassrohre wählbar angesteuert werden, sodass diese durchströmt oder verschlossen sind.

Vorteilhafterweise ist das Steuermittel zum Steuern des Lenkens in Abhängigkeit von einer Temperatur in zumindest einem der Bereiche vorgesehen. Eine weitere Möglichkeit besteht darin, dass das Steuermittel zum Steuern des Lenkens in Abhängigkeit von einer Temperatur im Fußboden vorgesehen ist. So kann einerseits einer Überhitzung des Fußbodens entgegengesetzt werden und andererseits der Fußboden über einen längeren Zeitraum warm gehalten werden zur Unterstützung der Gebäudeheizung.

Ein weiterer Vorteil der Gebäudeklimaanlage kann erreicht werden, wenn das solarthermische System einen Photovoltaikkollektor umfasst, dessen Rückseite zur Kühlung thermisch an einen Luftstrom zu einem Bereich des Solarluftkollektors angebunden ist. Die Leistung von Photovoltaik-Modulen hängt deutlich von deren Temperatur ab. So kann deren Leistung um rund 0,5 % je Kelvintemperaturerhöhung abnehmen. Wird ein Photovoltaikkollektor beispielsweise in eine doppelschalige Gebäudehülle integriert, kann er so durch den Luftstrom abgekühlt werden, sodass sich dessen Leistung erhöht.

Die auf das Verfahren gerichtete Aufgabe wird durch ein Verfahren zum Temperieren von Luft in einem Gebäude gelöst, bei dem erfindungsgemäß Luft mit einem Solarluftkollektor eines solarthermischen Systems erwärmt wird, die Luft durch das Speichervolumen eines Schüttgutspeichers geführt wird und diesen erwärmt und durch den Schüttgutspeicher geführte Luft zum Temperieren des Gebäudes verwendet wird. Das Gebäude kann mit verhältnismäßig einfachen Mitteln über einen langen Zeitraum geheizt und im Sommer gekühlt werden. Die aus dem Schüttgutspeicher herausgeführte Luft kann zur Heizung des Gebäudes direkt in das Gebäude eingeführt oder beispielsweise mit Hilfe eines Wärmetauschers zur Vorwärmung von Außenluft zum Heizen des Gebäudes verwendet werden.

Beim Hindurchführen von warmer Luft in den Schüttgutspeicher kühlt diese dort ab, wobei Feuchtigkeit auskondensiert. Sie reichert sich im Schüttgutspeicher an und fließt nach unten in das umgebende Erdreich. Um ein teilweises Fluten des Schüttgutspeichers zu vermeiden, ist der Schüttgutspeicher zweckmäßigerweise zumindest mit einem Rückstaubereich für Wasser ausgeführt, der das Kondenswasser aufnehmen und langsam an das tiefer gelegene Erdreich abgeben kann.

Durch den Feuchtigkeitsgehalt des Schüttgutspeichers entweder durch Kondenswasser oder auch durch Feuchtigkeit aus umgebendem Erdreich wird die aus dem Schüttgutspeicher herausgeführte Luft feucht sein. Bei einem Abkühlen der Luft im Schüttgutspeicher wird die Feuchte im wesentlichen 100 % betragen. Mit besonderem Vorteil kann daher die durch den Schüttgutspeicher geführte Luft zum Befeuchten eines Lebensmittelraums verwendet werden. Der Lebensmittelraum kann ein Feuchtlagerraum, ein Gewächsraum oder dergleichen sein.

Industriehallen sind üblicherweise mit einem Dach geringer Neigung ausgeführt. Durch das erfindungsgemäße Verfahren kann eine Sicherheit eines Hallendachs erhöht werden, indem die durch den Schüttgutspeicher geführte Luft dort erwärmt und in den Solarluftkollektor zum Abkühlen geführt wird. Das Dach kann in seiner äußersten Schicht erwärmt werden, sodass auf dem Dach lastender Schnee abgetaut wird. Einer zu hohen Dachlast von Schnee kann entgegengewirkt und eine übermäßige statische Belastung des Dachs vermieden werden.

Zweckmäßigerweise ist ein Schneesensor vorgesehen, beispielsweise ein Gewichtssensor oder ein optischer Sensor zur Erfassung einer Dachverformung, wobei ein Steuersystem ein Abtauen zweckmäßigerweise automatisch steuert wenn ein vorgegebener Sensorwert überschritten wird.

Die Luftströmung zum und vom Schüttgutspeicher kann von einem Steuersystem automatisch gesteuert werden, z.B. ein Heizen des Speichers bei einer vorgegebenen Temperaturdifferenz von Luft im Solarluftkollektor zum Schüttgutspeicher. Ebenfalls wird vorteilhafterweise ein Heizen des Gebäudes in Abhängigkeit einer Temperatur des Schüttgutspeichers automatisch gesteuert. Die Steuerung eines Heizens des Gebäudes geschieht zweckmäßigerweise unter Einbeziehen von entstehender Entfeuchtungswärme in einem Entfeuchter. Ebenfalls automatisiert kann die Steuerung eines Kühlens des Gebäudes in Abhängigkeit von Gebäudetemperatur und Temperatur des Schüttgutspeichers geschehen.

Weitere Vorteile ergeben sich aus der folgenden Zeichnungsbeschreibung. In der Zeichnung ist ein Ausführungsbeispiel der Erfindung dargestellt. Die Zeichnung und die Beschreibung enthalten zahlreiche Merkmale in Kombination, die der Fachmann zweckmäßigerweise auch einzeln betrachten und zu sinnvollen weiteren Kombinationen zusammenfassen wird.

Die einzige Figur zeigt ein Gebäude 2 mit einem Gebäuderaum 4 in Form einer Produktionshalle. Ein Dach 6 des Gebäudes 2 ist doppelschalig ausgeführt und weist nach oben hin ein nach außen schwarzes Blech 8 und darunter einen Hohlraum 10 auf, der sich über mehr als 80 % der Dachfläche erstreckt. Nach unten hin ist der Hohlraum 10 mit Hilfe einer Luftleitschicht mit einer darunter angeordneten Isolierung 12 wärmegedämmt, sodass Hitze vom Blech 8 nicht in den Gebäuderaum 4 hineinstrahlt. Anstelle des Blechs 8 kann eine oder mehrere Glasscheiben vorgesehen sein mit einer darunter angeordneten Luftleitschicht, die schwarz beschichtet ist, zwischen denen sich der Hohlraum 10 erstreckt.

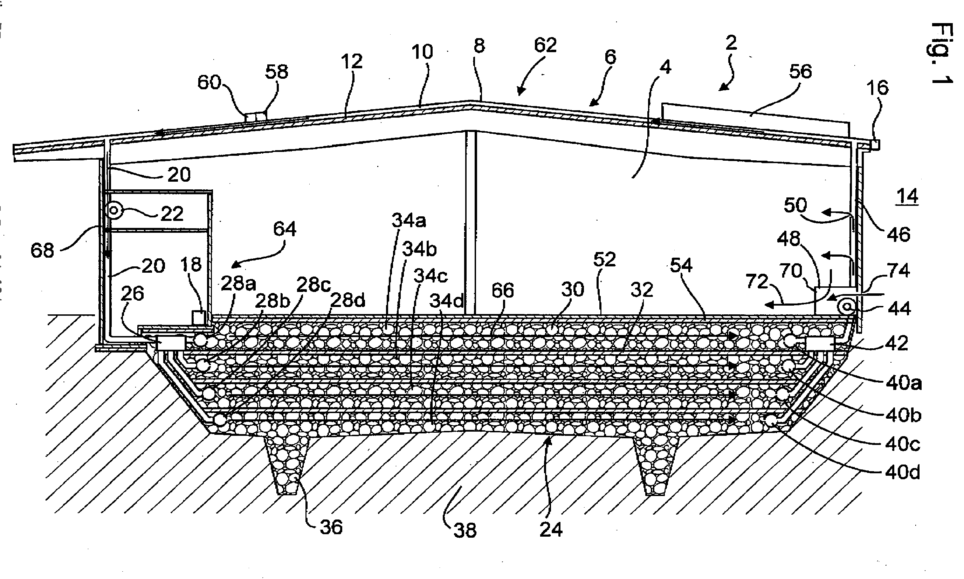

Der Hohlraum 10 weist eine Öffnung zu einer Gebäudeumgebung 14 auf, die durch ein Ventil 16 verschlossen werden kann. Gesteuert wird das Ventil 16 von einem elektronischen Steuermittel 18 in einen Nebenraum. Der Hohlraum 10 ist auf der gegenüber liegenden Seite über einen Kanal 20 mit einem Gebläse 22 zum Absaugen von Luft aus dem Hohlraum 10 und zum Einblasen der Luft in einen Schüttgutspeicher 24 verbunden. Der Kanal 22 mündet in eine vom Steuermittel 18 ansteuerbare Lenkmechanik 26, über die die eingeblasene Luft gezielt steuerbar in eines oder mehrere von vier Einlassrohren 28a-d lenkbar ist. Die Einlassrohre 28a-d sind senkrecht zur Papierebene der Figur 1 ausgerichtet und erstrecken sich entlang einer gesamten Einlassseite des von oben gesehen rechteckig angelegten Schüttgutspeichers 24. Verteilt auf ihre gesamte Länge ist jedes der Einlassrohre 28a-d mit einer Vielzahl von Einlässen versehen, durch die vom Gebläse 22 kommende Luft in den Schüttgutspeicher 24 eingeblasen werden kann.

Der Schüttgutspeicher 24 ist mit Geröll 30 in Form von Kopfsteinen gefüllt, von denen mehr als 80 % ein Volumen zwischen 2 Litern und 8 Litern haben. Drei Unterteilungen 32 in Form von Trennschichten, die in der Größe der gesamten horizontalen Ausdehnung des Schüttgutspeichers 24 ausgeführt sind, beispielsweise als wasserdurchlässige Vliese, unterteilen das Speichervolumen des Schüttgutspeichers 24 in vier übereinander gelegene Bereiche 34a-d. Die vertikale Dicke der einzelnen Bereiche 34a-d beträgt im Mittel rund 2 m. Nach unten hin ist der unterste Bereich 34d mit zwei jeweils 300 qm³ fassenden Rückstauabschnitten 36 versehen, um größere Mengen an Kondenswasser aufnehmen und langsam an ein umgebendes Erdreich 38 abgeben zu können.

Auf einer der Einlassseite des Schüttgutspeichers 24 gegenüberliegenden Auslassseite sind in den Schüttgutspeicher 24 vier Auslassrohre 40a-d eingebettet, die jeweils wiederum mit einer Lenkmechanik 42 und über ein optionales Gebläse 44 mit einem Kanal 46 verbunden sind. Der Kanal 46 ist an einen Entfeuchter 48 angeschlossen, über den vom Gebläse 44 aus dem Schüttgutspeicher 24 angesaugte Luft in den Gebäuderaum 4 eingeblasen werden kann. Zusätzlich ist der Kanal 46 mit Öffnungen 50 versehen, durch die Luft aus dem Schüttgutspeicher 24 direkt in den Gebäuderaum 4 eintreten kann.

Anstelle eines Kanals 46 kann das Gebläse 44 mit einer Mehrzahl nebeneinander angeordneter Kanäle 46 verbunden sein, über die der Gebäuderaum 4 in seiner gesamten Tiefe beheizt werden kann. Alternativ zu den Kanälen 20, 46 sind doppelschalige Wandelemente vorteilhaft, durch die die warme Luft aus dem Hohlraum 10 beziehungsweise dem Schüttgutspeicher 24 über einen größeren Längsbereich der Halle geführt werden kann. Anstelle der einzelnen Gebläse 22, 44 können jeweils mehrere Gebläse 22, 44 vorhanden sein.

Der Gebäuderaum 4 hat einen Fußboden 52 in Form einer monolithischen Betonplatte, unter dem eine Wärmedämmschicht 54 angeordnet ist. Unter der Wärmedämmschicht 54 beginnt sofort das Geröll 30 des Schüttgutspeichers 24. Je nach Form des Erdreichs 38 kann der Schüttgutspeicher 24 auch gegen das Erdreich 38 mit einer Wärmedämmschicht versehen sein.

Im Dach 6 des Gebäudes 2 ist ein Photovoltaikkollektor 56 derart montiert, dass durch den Hohlraum 10 geführte Luft an der Unterseite des Photovoltaikkollektors 56 entlang streicht und diesen kühlt. Außerdem sind im Dach 6 ein Temperatursensor 58 und ein Schneesensor 60 angebracht.

Der Hohlraum 10 und das nach oben hin geschwärzte Blech 8 bilden einen Solarluftkollektor 62, der die Luft im Hohlraum 10 durch Sonneneinstrahlung erwärmt, im Sommer bis auf 80°C und mehr. Der Kanal 20, das Gebläse 22 und die Einlassrohre 28a-d bilden ein Lüftungssystem 64, mit dem die so erwärmte Luft in den Schüttgutspeicher 24 eingeblasen werden kann. Die Auslassrohre 40a-d, die Lenkmechanik 42, das Gebläse 44 und den Kanal 46 sind ebenfalls Bestandteil des Lüftungssystems 64.

Im Sommer wird vom Solarluftkollektor 62 erhitzte Luft in den Schüttgutspeicher 24 eingeblasen und strömt darin von den Einlassrohren 28a-d zu den Auslassrohren 40a-d in einer Hauptströmungsrichtung 66, die im Mittel quer zur Richtung der Ein- und Auslassrohre 28a-d, 40a-d ausgerichtet ist und durchströmt hierbei das gesamte Speichervolumen des Schüttgutspeichers 24. Die durch den Schüttgutspeicher 24 strömende Luft gibt Wärme an die Steine 30 ab und kühlt hierbei auf ihrem Weg zu den Auslassrohren 40a-d ab. Anschließend wird die Luft in einem geschlossenen Kreislauf zum Solarluftkollektor 62 zurückgeführt, dort wieder erwärmt und erneut zum Schüttgutspeicher 24 geführt.

Alternativ kann die abgekühlte Luft durch die Öffnungen 50 in den Gebäuderaum 4 eingeblasen werden, wobei dem Solarluftkollektor 62 durch das Ventil 16 Umgebüngsluft zur Ergänzung der Luft im Lüftungssystem 64 zugeführt wird. Ist die kühle Luft aus dem Schüttgutspeicher für ein direktes Einblasen in den Gebäuderaum 4 zu feucht, so kann sie über den Entfeuchter 48 geführt und anschließend zur Klimatisierung in den Gebäuderaum 4 eingeblasen werden.

Je nach Bedarf der Qualität der in den Gebäuderaum 4 eingeblasenen Luft kann anstelle oder zusätzlich zum Entfeuchter 48 ein Wärmetauscher 70 vorgesehen sein, durch den ein offener Heizkreislauf 72 im Gebäuderaum 4 von einem beispielsweise in sich geschlossenen Luftkreislauf vom Solarluftkollektor 62 zum Schüttgutspeicher 24 und zurück luftmäßig abgekoppelt werden kann. Zusätzlich zum Wärmetauscher 70 kann eine weitere Heizung vorgesehen sein, sodass die vom Schüttgutspeicher 24 erwärmte Luft zum Vorheizen der Luft im Heizkreislauf 72 verwendet wird. Des Weiteren kann die aus dem Schüttgutspeicher 24 austretende warme Luft im Winter zur Vorwärmung von Außenluft genutzt werden, die durch einen entsprechenden Einlass 74 dem Wärmetauscher 70 von außen zugeführt wird.

Durch die Einteilung des Schüttgutspeichers 24 in Bereiche 34a-d kann eine intelligente Beladung mit Wärme erfolgen. Beispielsweise wird im Frühsommer zunächst der zweitoberste Bereich 34b mit Wärme beladen. Die Temperatur der aus dem Bereich 34b austretenden Luft wird über einen Temperatursensor, der beispielsweise in der Lenkmechanik 42 integriert sein kann, erfasst und die Temperatur wird vom Steuermittel 18 ausgewertet. Steigt die Temperatur im Laufe des Sommers über eine zur Klimatisierung des Gebäuderaums 4 geeignete Temperatur, so veranlasst das Steuermittel 18 eine Umschaltung in der Lenkmechanik 26, sodass nunmehr der nächst tiefer gelegene Bereich 34c mit Wärme beladen wird. Auch die Lenkmechanik 42 kann umgeschaltet werden, sodass Luft den Schüttgutspeicher 24 nur über das Auslassrohr 40c verlassen kann. Später kann in einem nächsten Schritt die Wärmebeladung auf den untersten Bereich 34d umgeschaltet werden

Durch das bereichsweise Aufheizen des Schüttgutspeichers steht stets kühle Luft zur Klimatisierung des Gebäuderaums 4 zur Verfügung. Zwar lässt sich nicht vermeiden, dass Wärme aus den unteren Bereichen 34b-d nach oben in den obersten Bereich 34a steigt und dort den Fußboden 52 erwärmt. Durch die Unterteilungen 32 wird der Wärmeübertrag in den obersten Bereich 34a jedoch sehr gebremst, sodass sich dieser nur sehr langsam im Laufe des Sommers erwärmt. Je nach Wärmebedarf im Winter kann der oberste Bereich 34a gegen Ende des Sommers zusätzlich mit Wärme beladen werden, sodass seine Wärme direkt an den Fußboden 52 als Fußbodenheizung abgegeben werden kann. Die Wärmedämmschicht 54 verhindert hierbei ein Überhitzen des Fußbodens 52.

Zur Messung der Temperatur des Fußbodens 52 ist im Fußboden 52 ein nicht dargestellter Temperatursensor angebracht. Die Temperatur des Fußbodens 52 kann im Herbst und Winter außer durch die gezielte Wärmeverteilung in den Schüttgutspeicher 24 hinein zusätzlich dadurch geregelt werden, dass Wärme gezielt aus einem oder mehreren der Bereiche 34a-d entnommen wird. Ist der Fußboden trotz der Wärmedämmschicht 54 zu heiß, so kann der oberste Abschnitt 34a im Herbst als erstes gekühlt werden, indem kühle Außenluft, die nicht mehr wesentlich durch den Solarluftkollektor 62 erwärmt wurde, in den obersten Bereich 34a eingeblasen wird. Die Luft erwärmt sich beim Durchströmen dieses Abschnitts 34a und kann zur Beheizung des Gebäuderaums 4 verwendet werden. Ist die Temperatur des Fußbodens 52 angenehm, so kann Wärme aus einem oder mehreren der weiteren Bereiche 34b-d entnommen werden. Welcher der Bereiche 34a-d entladen wird, wird von dem Steuermittel 18 in Abhängigkeit von einerseits der Temperatur in den Bereichen 34a-d - gemessen durch einen oder mehrere Temperatur-sensoren z.B. in der Lenkmechanik 42 - gesteuert, wobei auch ein Wärmebedarf in die Steuerung eingehen kann, beispielsweise durch Messung der Außentemperatur an einer Wand 68 des Gebäudes 2.

Es ist außerdem vorteilhaft, in die vier Bereiche 34a-d jeweils mehrere Temperatursensoren zur Überwachung der Temperatur an verschiedenen Orten der Bereiche 34a-d einzubringen. Auf diese weise kann ein Aufwärmverhalten oder Abkühlverhalten des Schüttgutspeichers 24 und insbesondere jedes seiner Bereiche 34a-d überwacht werden und es kann ein Wärmeeintrag bzw. eine Wärmeabfuhr so gesteuert werden, dass ein Bereich 34a-d beispielsweise über die gesamte Länge eines Auslassrohrs 28a-d gleichmäßig erwärmt oder abgekühlt wird.

Hierzu und um eine weitergehende Temperaturregelung des Fußbodens 52 zu erreichen, können die Vielzahl der Einlässe der Einlassrohre 28a-d einzeln oder in Gruppen durch das Steuermittel 18 ansteuerbar sein. Hierdurch kann der Eintrag von Wärme oder die Abfuhr von Wärme - insbesondere aus dem obersten Bereich 34a - derart bereichsweise gesteuert werden, dass zwei in Längsrichtung des Einlassrohrs 28a versetzt angeordnete Bereich des Fußbodens 52 unterschiedlich warm sind. In gleicher Weise können die Luftauslässe der Auslassrohre 40a-d einzeln oder in Gruppen vom Steuermittel 18 geschaltet werden, sodass gradlinige Luftströmungen in Hauptströmungsrichtung 66 oder erzwungene Diagonalströmungen durch den Schüttgutspeicher 24 erzeugt werden können. Hierdurch kann eine Wärmeverteilung oder eine Auskühlung im Schüttgutspeicher 24 besonders komfortabel im Hinblick auf eine Heizung des Gebäuderaums 4 gesteuert werden.

Im Sommer kann kühle Luft aus dem Schüttgutspeicher 24 in einen geschlossenen oder teiloffenen Kreislauf in den Solarluftkollektor 62 zurückgeführt werden. Hierdurch wird der Photovoltaikkollektor 56 besonders effektiv gekühlt und kann mit einem hohen Wirkungsgrad arbeiten. Eine Aufteilung der kalten, aus dem Schüttgutspeicher 24 kommenden Luft einerseits als geschlossener Kreislauf zum Solarluftkollektor 62 und andererseits in den Gebäuderaum 4 wird vom Steuermittel 18 in Abhängigkeit von der Temperatur im Gebäudeinnenraum 4 und der Temperatur des Phötovoltaikkollektors 56 gesteuert.

Durch den hohen Feuchtigkeitsgehalt der aus dem Schüttgutspeicher 24 austretenden Luft kann der Gebäuderaum 4 auf einem hohen Luftfeuchtigkeitsniveau gehalten werden. Die beschriebene Gebäudeklimaanlage ist hierdurch besonders geeignet zum Klimatisieren eines Lebensmittelsraums, beispielsweise eines Feuchtlagerraums oder eines Gewächsraums. Eine Luftfeuchtigkeit des Gebäuderaums 4 wird dann vom Steuermittel 18 überwacht und eine Entfeuchtung der aus dem Schüttgutspeicher 24 austretenden Luft durch den Entfeuchter 48 entsprechend gesteuert.

Außerdem überwacht das Steuermittel 18 den Schneesensor 60. Steigt ein Signal des Schneesensors 60 über einen vorbestimmten Wert, beispielsweise hervorgerufen durch eine hohe Schneedecke auf dem Dach 6, so steuert das Steuermittel 18 die Luftführung derart, dass im Schüttgutspeicher 24 erwärmte Luft in den Solarluftkollektor 62 - also in den Hohlraum 10 - geführt wird. Hierdurch wird das äußere Blech 8 erwärmt und der darauf lagernde Schnee schmilzt. Auf diese Weise kann das Dach 6 abgetaut werden, so lange, bis der Schneesensor 60 einen unkritischen Wert meldet und das Abtauen des Dachs 6 gestoppt werden kann. Auf diese Weise kann zuverlässig vermieden werden, dass das Dach 6 durch eine große Schneemasse überlastet wird.

### Bezugszeichenliste

- 2: Gebäude
- 4: Gebäuderaum
- 6: Dach
- 8: Blech
- 10: Hohlraum
- 12: Isolierung
- 14: Gebäudeumgebung
- 16: Ventil
- 18: Steuermittel
- 20: Kanal
- 22: Gebläse
- 24: Schüttgutspeicher
- 26: Lenkmechanik
- 28a-d: Einlassrohr
- 30: Geröll
- 32: Unterteilung
- 34a-d: Bereich
- 36: Rückstauabschnitt
- 38: Erdreich
- 40a-d: Auslassrohr
- 42: Lenkmechanik
- 44: Gebläse
- 46: Kanal
- 48: Entfeuchter
- 50: Öffnung
- 52: Fußboden
- 54: Wärmedämmschicht
- 56: Photovoltaikkollektor
- 58: Temperatursensor
- 60: Schneesensor
- 62: Solarluftkollektor
- 64: Lüftungssystem
- 66: Hauptströmungsrichtung
- 68: Wand
- 70: Wärmetauscher
- 72: Heizkreislauf
- 74: Einlass

## Patentansprüche

1. Gebäudeklimaanlage mit einem solarthermischen System mit einem Solarluftkollektor (62), einem Schüttgutspeicher (24) als wärmespeicher und einem Lüftungssystem (64) zum Einbringen von Luft aus dem Solarluftkollektor (62) in den Schüttgutspeicher (24) zum Durchströmen des Schüttgutspeichers (24) mit der Luft und zur Entnahme von Luft aus dem Schüttgutspeicher (24) zum Temperieren eines Gebäudes (2).

2. Gebäudeklimaanlage nach Anspruch 1,
**dadurch gekennzeichnet, dass** der Schüttgutspeicher (24) ein Geröllspeicher im Erdreich (38) unter einem Fußboden (52) des Gebäudes (2) ist.

3. Gebäudeklimaanlage nach Anspruch 2,
**dadurch gekennzeichnet, dass** der Schüttgutspeicher (24) und der Fußboden (52) weniger als 1 m voneinander beabstandet und von einer Temperierschicht (54) getrennt sind, die eine mehr als 5 x so hohe Wärmedämmung aufweist, wie das Gestein (30) des Schüttgutspeichers (24).

4. Gebäudeklimaanlage nach einem der vorhergehenden Ansprüche,
**dadurch gekennzeichnet, dass** der Schüttgutspeicher (24) mit Steinen gefüllt ist, von denen zumindest 50 Gewichts-% größer als 1 1 sind.

5. Gebäudeklimaanlage nach einem der vorhergehenden Ansprüche,
**dadurch gekennzeichnet, dass** der Solarluftkollektor (24) von einer doppelschaligen Gebäudehülle gebildet ist.

6. Gebäudeklimaanlage nach einem der vorhergehenden Ansprüche,
**dadurch gekennzeichnet, dass** das Lüftungssystem (64) zum Erzeugen einer Hauptströmungsrichtung (66) von Luft im Schüttgutspeicher (24) vorbereitet ist und ein Einlassrohr (28a-d) und ein Auslassrohr (40a-d) aufweist, die quer zur Hauptströmungsrichtung (66) angeordnet sind und jeweils eine Vielzahl von Einlässen in den bzw. Auslässen aus dem Schüttgutspeicher (24) umfassen.

7. Gebäudeklimaanlage nach einem der vorhergehenden Ansprüche,
**dadurch gekennzeichnet, dass** das Lüftungssystem (64) mehrere verschieden tiefe Einlassrohre (28a-d) und/oder Auslassrohre (40a-d) aufweist, die jeweils eine Vielzahl von Einlässen in den bzw. Auslässen aus dem Schüttgutspeicher (24) umfassen.

8. Gebäudeklimaanlage nach einem der vorhergehenden Ansprüche,
**gekennzeichnet durch** ein ein elektronisches Steuermittel (18) aufweisendes Steuersystem zum auswählbaren Lenken von Einlassluft und/oder Auslassluft in verschiedene Bereiche (34a-d) bzw. aus verschiedenen Bereichen (34a-d) des Schüttgutspeichers (24).

9. Gebäudeklimaanlage nach Anspruch 8,
**dadurch gekennzeichnet, dass** das Steuermittel (18) zum Steuern des Lenkens in Abhängigkeit von einer Temperatur in einem der Bereiche (34a-d) vorgesehen ist.

10. Gebäudeklimaanlage nach Anspruch 8 oder 9,
**dadurch gekennzeichnet, dass** das Steuermittel (18) zum Steuern des Lenkens in Abhängigkeit von einer Temperatur in einem Fußboden (52) des Gebäudes (2) vorgesehen ist.

11. Gebäudeklimaanlage nach einem der vorhergehenden Ansprüche,
**dadurch gekennzeichnet, dass** das solarthermische System einen Photovoltaikkollektor (56) umfasst, dessen Rückseite zur Kühlung thermisch an einen Luftstrom zu einem Bereich des Solarluftkollektors (62) angebunden ist.

12. Verfahren zum Temperieren von Luft in einem Gebäude (2), bei dem Luft mit einem Solarluftkollektor (62) eines solarthermischen Systems erwärmt wird, die Luft durch das Speichervolumen eines Schüttgutspeichers (24) geführt wird und diesen erwärmt und durch den Schüttgutspeicher (24) geführte Luft zum Temperieren des Gebäudes (2) verwendet wird.

13. Verfahren nach Anspruch 12,
**dadurch gekennzeichnet, dass** die durch den Schüttgutspeicher (24) geführte Luft zum Befeuchten eines Lebensmittelraums verwendet wird.

14. Verfahren nach Anspruch 12 oder 13,
**dadurch gekennzeichnet, dass** die durch den Schüttgutspeicher (24) geführte Luft dort erwärmt und in den Solarluftkollektor (62) zum Abkühlen geführt wird.
